# EUROPÄISCHE PATENTANMELDUNG

(11) **EP 4 776 790 A1**
(43) Veröffentlichungstag der Anmeldung: **15.07.2026**
(21) Anmeldenummer: 26151438.4
(22) Anmeldetag: 12.01.2026
(51) Int. Cl.: H10D 84/01, H10D 84/00, H02M 7/5387, H02M 7/00, H01R 25/16, H01R 12/57, H05K 7/14

(54) **VORRICHTUNG FÜR EINEN STROMWANDLER, STROMWANDLER UND FAHRZEUG**

(30) Priorität: 14.01.2025 DE 102025101191
(71) Anmelder: Volkswagen Aktiengesellschaft, 38440 Wolfsburg (DE)
(72) Erfinder: Bayer, Dr. Christoph Friedrich, 38440 Wolfsburg (DE); Müller, Jens Uwe, 38440 Wolfsburg (DE); Zimmermann, Matthias, 38440 Wolfsburg (DE); Kramm, Michael, 38440 Wolfsburg (DE); Sommer, Dr. Christian, 38440 Wolfsburg (DE)

(57) **Zusammenfassung**

Die Erfindung betrifft eine Vorrichtung (100) für einen Stromwandler (200), umfassend:
- mindestens eine Trennschicht (1),
- mindestens eine Leiterschicht (2),
- mindestens einen Leistungshalbleiter (3),

wobei die mindestens eine Trennschicht (1), die mindestens eine Leiterschicht (2) und der mindestens eine Leistungshalbleiter (3) zumindest teilweise in einer Vergussmasse (M) vergossen sind, wobei die Vorrichtung (100) mindestens eine Anschlussfläche (K) zur elektrischen Kontaktierung aufweist, wobei die Vergussmasse (M) die mindestens eine Anschlussfläche (K) nicht bedeckt, wobei die mindestens eine Anschlussfläche (K) planar ausgebildet ist, wobei die mindestens eine Anschlussfläche (K) als eine Teilfläche der mindestens einen Leiterschicht (2) ausgebildet ist oder in einer Ebene parallel über der mindestens einen Leiterschicht (2) angeordnet ist,
sowie einen Stromwandler (200) und ein Fahrzeug (300).

## Beschreibung

Die Erfindung betrifft eine Vorrichtung für einen Stromwandler, einen Stromwandler und ein Fahrzeug.

In leistungselektronischen Schaltungen, die beispielsweise in Wechselrichtern für Elektrofahrzeuge Anwendung finden, ist eine hohe Schaltgeschwindigkeit von darin verbauten Leistungshalbleitern wie z.B. MOSFETs gewünscht. Es ist bekannt, dass die Schaltgeschwindigkeit vor allem durch eine niedrigere parasitäre Induktivität in der leistungselektronischen Schaltung, insbesondere in der sogenannten Kommutierungszelle, verbessert werden kann.

Aus der DE 10 2019 109 461 A1 ist ein Leistungsmodul mit mindestens einem Leistungshalbleiterschalter und einem Zwischenkreiskondensator für einen Stromrichter bekannt, wobei der Zwischenkreiskondensator durch eine Schraubverbindung mit dem Leistungsmodul verbunden ist. Nachteilig ist jedoch, dass der Zwischenkreiskondensator nur durch eine Verschraubung an das Leistungsmodul angebunden werden kann und die parasitäre Induktivität weiterhin zu hoch ist.

Es stellt sich das technische Problem, eine Vorrichtung für einen Stromwandler, einen Stromwandler und ein Fahrzeug zu schaffen, welche eine Flexibilität in der Art der mechanischen Anbindung erhöhen und eine parasitäre Induktivität weiter verringern können.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird eine Vorrichtung für einen Stromwandler, umfassend:
- mindestens eine Trennschicht,
- mindestens eine Leiterschicht,
- mindestens einen Leistungshalbleiter,
wobei die mindestens eine Trennschicht, die mindestens eine Leiterschicht und der mindestens eine Leistungshalbleiter zumindest teilweise in einer Vergussmasse vergossen sind, wobei die Vorrichtung mindestens eine Anschlussfläche zur elektrischen Kontaktierung aufweist, wobei die Vergussmasse die mindestens eine Anschlussfläche nicht bedeckt, wobei die mindestens eine Anschlussfläche planar ausgebildet ist, wobei die mindestens eine Anschlussfläche als eine Teilfläche der mindestens einen Leiterschicht ausgebildet ist oder in einer Ebene parallel über der mindestens einen Leiterschicht angeordnet ist.

Die Vorrichtung hat zum Vorteil, dass z.B. ein Zwischenkreiskondensator direkt mit der Leiterschicht oder in einer Ebene parallel über der Leiterschicht an die Vorrichtung elektrisch angebunden werden kann. Dies verkürzt Leitungswege und verringert somit parasitäre Effekte. Beiden Alternativen ist ferner gemein, dass die planare Anschlussfläche eine erhöhte Flexibilität in der Art der mechanischen Anbindung bietet. Beispielsweise kann die Anschlussfläche durch Stromschienen, Litzen und/oder Bürsten kraft-, form- und/oder stoffschlüssig kontaktiert werden. Die genannten Alternativen sind somit in einer Weise miteinander verbunden, dass sie eine einzige allgemeine erfinderische Idee verwirklichen.

Weiter vorgeschlagen wird ein Stromwandler, umfassend mindestens eine Vorrichtung nach einer in dieser Offenbarung beschriebenen Ausführungsform. Der Stromwandler kann z.B. als ein Wechselrichter, insbesondere als ein Pulswechselrichter, ausgebildet sein. Der Stromwandler kann insbesondere zur Verwendung in einem Fahrzeug ausgebildet sein. Der Stromwandler kann zwischen einer Traktionsbatterie des Fahrzeugs und einem Elektromotor des Fahrzeugs angeordnet sein, um z.B. Gleichstrom aus der Traktionsbatterie in Wechselstrom für den Elektromotor umzuwandeln. Der Stromwandler kann ferner einen Zwischenkreiskondensator umfassen. Die Vorrichtung kann z.B. eingangsseitig an den Zwischenkreiskondensator und ausgangsseitig an den Elektromotor angeschlossen sein. Die Vorrichtung kann Teil einer Kommutierungszelle des Stromwandlers sein. Die Vorrichtung kann auch als Leistungsmodul oder Leistungsbox bezeichnet werden.

Weiter vorgeschlagen wird ein Fahrzeug, umfassend mindestens einen Stromwandler nach einer in dieser Offenbarung beschriebenen Ausführungsform. Das Fahrzeug kann z.B. als ein PKW, Bus, LKW, Schienenfahrzeug, Luftfahrzeug oder Wasserfahrzug ausgebildet sein. Das Fahrzeug kann durch die verringerte parasitäre Induktivität im elektrischen Betrieb eine höhere Reichweite erzielen, da durch die verringerte parasitäre Induktivität z.B. Schaltzeiten der Leistungshalbleiter verbessert werden und somit elektrische Verluste bei der Stromwandlung minimiert werden können.

Die im Rahmen dieser Offenbarung für die Vorrichtung erläuterten technischen Effekte und Vorteile treffen selbstverständlich auch für den Stromwandler und das Fahrzeug zu und umgekehrt.

Die Trennschicht kann auch als Trägersubstrat oder Schaltungsträger bezeichnet werden. Die Trennschicht ist elektrisch nichtleitend. Die Trennschicht kann aus einem nicht-metallischen Werkstoff wie z.B. Keramik hergestellt sein. Auf einer Oberseite der Trennschicht kann die Leiterschicht angeordnet sein. An einer Unterseite der Trennschicht kann eine Metallschicht angeordnet sein. Insbesondere kann eine Unterseite der Metallschicht zur Anbindung eines Kühlkörpers an die Vorrichtung dienen. Die Metallschicht kann insbesondere massegebunden sein.

Die Leiterschicht kann auch als Metallisierungsschicht bezeichnet werden. Die Leiterschicht ist elektrisch leitend und kann z.B. aus Kupfer hergestellt sein. Die Leiterschicht ist insbesondere planar ausgebildet. Die Leiterschicht kann als eine Platte ausgebildet sein. Eine Oberseite der Leiterschicht kann eine Ebene sein oder aufspannen. Die Leiterschicht kann mehrere Leiterbahnen aufweisen, die unterschiedliche elektrische Potentiale aufweisen können. Zwischen den Leiterbahnen können selbstverständliche isolierende Lücken in der Leiterschicht bestehen, die z.B. mit der Vergussmasse gefüllt sind. Eine erste Leiterbahn kann z.B. über den Zwischenkreiskondensator mit einem Pluspol einer Hochvoltbatterie des Fahrzeugs verbunden sein und daher ein hohes elektrisches Potential aufweisen. Eine weitere Leiterbahn kann z.B. über den Zwischenkreiskondensator mit einem Minuspol einer Hochvoltbatterie des Fahrzeugs verbunden sein und daher ein niedriges elektrisches Potential aufweisen.

Der Leistungshalbleiter kann ein Transistor sein oder zumindest einen solchen umfassen. Der Transistor kann z.B. ein MOSFET oder IGBT sein. Der Leistungshalbleiter kann elektrisch mit der Leiterschicht verbunden sein, z.B. durch Verlöten oder Sintern. Der Leistungshalbleiter kann insbesondere auf der zuvor erwähnten ersten Leiterbahn angeordnet sein und z.B. über einen Bonddraht mit der weiteren Leiterbahn elektrisch verbunden sein.

Die Vergussmasse kann ein fließfähiger Kunststoff wie Polyurethan oder Epoxidharz sein. Im ausgehärteten Zustand können freie Bereiche der Oberfläche der Vorrichtung, insbesondere der Oberfläche der Trennschicht, der Leiterschicht und/oder des Leistungshalbleiters mit der Vergussmasse bedeckt sein. Die Vergussmasse dient dem passiven Schutz der Vorrichtung vor Beschädigungen und Verschmutzungen.

Die Anschlussfläche ist nicht von der Vergussmasse bedeckt, sodass die Anschlussfläche von außen kontaktierbar ist. Die Anschlussfläche kann z.B. als ein Anschluss eines Gleichstromterminals der Vorrichtung ausgebildet sein. Die Anschlussfläche kann z.B. eine Größe in einem Bereich von 0,1 Quadratzentimetern bis fünf Quadratzentimetern aufweisen, insbesondere 0,5 Quadratzentimetern bis fünf Quadratzentimetern. Die Anschlussfläche ist planar, d.h. eben und gerade, ausgebildet. Insbesondere weist die Vorrichtung mindestens eine erste planare Anschlussfläche für ein erstes elektrisches Potential und mindestens eine weitere planare Anschlussfläche für ein weiteres elektrisches Potential auf. Insbesondere ist die erste Anschlussfläche als eine Teilfläche der mindestens einen ersten Leiterbahn ausgebildet oder in einer Ebene parallel über der mindestens einen ersten Leiterbahn angeordnet. Weiter insbesondere ist die weitere Anschlussfläche als eine Teilfläche der mindestens einen weiteren Leiterbahn ausgebildet oder in einer weiteren Ebene (oder der zuvor erwähnten Ebene) parallel über der mindestens einen weiteren Leiterbahn angeordnet. Hierdurch können die erste und die weitere Anschlussfläche als vollwertiges Gleichstromterminal der Vorrichtung fungieren - mit den eingangs erwähnten Vorteilen.

Wenn die Anschlussfläche in der Ebene parallel über der Leiterschicht angeordnet ist, dann ist die Anschlussfläche vertikal zu der Oberseite der Leiterschicht versetzt. Insbesondere überlappt die Anschlussfläche die Leiterschicht in einer Raumrichtung, die z.B. parallel zu einer Stromflussrichtung durch die Leiterschicht orientiert ist. Die Ebene, in welcher die Anschlussfläche angeordnet ist, kann z.B. um höchstens fünf Zentimeter von der Oberseite der Leiterschicht parallel versetzt sein.

In einer Ausführungsform weist die Vergussmasse mindestens eine Aussparung auf, wobei die mindestens eine Anschlussfläche einen Boden der Aussparung ausbildet. Auf diese Weise können die zuvor erwähnten freien Bereiche der Oberfläche der Vorrichtung, insbesondere der Leiterschicht - abgesehen von der Anschlussfläche - mit Vergussmasse bedeckt sein. Mit anderen Worten: Durch die Aussparung kann die Anschlussfläche eine Teilfläche der Leiterschicht sein, ohne dass auf den Schutz durch die Vergussmasse verzichtet werden muss. Die Aussparung kann z.B. durch eine Maskierung der Leiterschicht in dem Bereich der Anschlussfläche beim Vergießen der Vergussmasse hergestellt werden. Die Aussparung kann konisch geformt sein, sodass ein Kontaktieren der Anschlussfläche von außen erleichtert ist.

In einer Ausführungsform ist die mindestens eine Anschlussfläche mittels mindestens eines Abstandhalters in der Ebene parallel über der mindestens einen Leiterschicht angeordnet. Auf diese Weise kann die Anschlussfläche zu der Leiterschicht beabstandet sein, ohne die eingangs erläuterte Flexibilität der mechanischen Anbindung zu verlieren. Der Abstandhalter kann z.B. aus Kupfer hergestellt sein. Der Abstandhalter kann z.B. quaderförmig sein oder als ein gebogenes Blech ausgebildet sein. Die Anschlussfläche kann z.B. eine Oberseite des Abstandhalters sein. Eine Unterseite des Abstandhalters kontaktiert z.B. die Leiterschicht, sodass eine elektrische Verbindung zwischen der Anschlussfläche und der Leiterschicht hergestellt ist. Der Abstandhalter ist insbesondere stoffschlüssig mit der Leiterschicht verbunden. Beispielsweise kann eine Unterseite des Abstandhalters durch Schweißen mit einer Oberseite der Leiterschicht verbunden werden.

In einer Ausführungsform ist die mindestens eine Anschlussfläche flächenbündig in einer Oberseite der Vergussmasse angeordnet. Auf diese Weise kann der Abstandhalter in der Vergussmasse vergossen werden, ohne die Anschlussfläche mit Vergussmasse zu bedecken. Dies verbessert den Schutz der Vorrichtung. Insbesondere ist z.B. die zuvor erläuterte Aussparung in der Vergussmasse nicht notwendig. Vielmehr kann der Abstandhalter z.B. stoffschlüssig mit der Leiterschicht verbunden werden und die Vorrichtung daraufhin wie üblich in der Vergussmasse vergossen werden. Die Anschlussfläche kann für den Vorgang des Vergießens maskiert werden. Die Vergussmasse kann die Anschlussfläche z.B. umrahmen. Die Oberseite der Vergussmasse kann eine Oberseite der Vorrichtung ausbilden.

In einer Ausführungsform weist der mindestens eine Abstandhalter ein C-Profil auf. Hierdurch kann der Abstandhalter besonders materialsparend hergestellt werden, insbesondere im Vergleich zu einem Quader. Dies reduziert die Materialkosten und das Gewicht der Vorrichtung. Das C-Profil kann z.B. eine Querschnittsform des Abstandhalters sein. Der Abstandhalter kann z.B. als sogenanntes C-Blech ausgebildet sein. Das C-Blech kann z.B. ein zweifach gebogenes Blech sein. Das C-Blech kann eine konstante Blechdicke aufweisen. Eine Oberseite des C-Profils kann die planare Anschlussfläche ausbilden. Eine Unterseite des C-Profils kann mit der Leiterschicht verbunden sein, z.B. durch Laserschweißen.

In einer Ausführungsform weist die mindestens eine Leiterschicht mindestens eine erste Leiterbahn mit einem ersten elektrischen Potential und mindestens eine weitere Leiterbahn mit einem weiteren elektrischen Potential auf, wobei der mindestens eine Abstandhalter die mindestens eine erste Leiterbahn kontaktiert, wobei der mindestens eine Abstandhalter derart ausgebildet ist, dass der mindestens eine Abstandhalter die mindestens eine weitere Leiterbahn in einer Raumrichtung zumindest teilweise überlappt. Aufgrund der Überlappung können die elektromagnetischen Effekte zwischen der weiteren Leiterbahn und dem Abstandhalter besser eingegrenzt werden. Da eine Oberseite des Abstandhalters als Anschlussfläche dienen kann, kann durch die erläutere Überlappung zudem die Anschlussfläche auf einfache Weise vergrößert werden. Eine Querschnittsform des Abstandhalters kann ein z.B. T-Profil aufweisen, um die Überlappung zu erzielen. Die Raumrichtung, in welcher der Abstandhalter die weitere Leiterbahnen überlappt, ist insbesondere orthogonal zu einer Stromflussrichtung durch die weitere Leiterbahn orientiert. Die weitere Leiterbahn weist insbesondere die eingangs erläuterte weitere Anschlussfläche auf, um die Vorrichtung z.B. an einen Minuspol einer Hochvoltbatterie anzuschließen. Im Bereich der Überlappung der weiteren Leiterbahn kann selbstverständlich Vergussmasse zwischen dem Abstandhalter und der weiteren Leiterbahn angeordnet sein, um die unterschiedlichen elektrischen Potentiale voneinander zu isolieren. Eine Distanz zwischen dem Abstandhalter und der mindestens einen weiteren Leiterbahn im Bereich der Überlappung kann z.B. zwischen 0,1 mm und fünf Zentimetern betragen.

In einer Ausführungsform kontaktiert der mindestens eine Abstandhalter mehrere erste Leiterbahnen eines ersten elektrischen Potentials, wobei zwischen den ersten Leiterbahnen mindestens eine weitere Leiterbahn eines weiteren elektrischen Potentials angeordnet ist, wobei der mindestens eine Abstandhalter derart ausgebildet ist, dass der mindestens eine Abstandhalter die mindestens eine weitere Leiterbahn in einer Raumrichtung vollständig überlappt. Aufgrund der vollständigen Überlappung der weiteren Leiterbahn können die elektromagnetischen Effekte zwischen den weiteren Leiterbahn und dem Abstandhalter noch besser eingegrenzt werden. Eine Querschnittsform des Abstandhalters kann z.B. ein Doppel-T-Profil aufweisen, um die vollständige Überlappung der weiteren Leiterbahn zu erzielen. Die Raumrichtung, in welcher der Abstandhalter die weitere Leiterbahnen überlappt, ist insbesondere orthogonal zu einer Stromflussrichtung durch die weitere Leiterbahn orientiert.

In einer Ausführungsform weist der mindestens eine Abstandhalter mindestens eine Öffnung in der mindestens einen Anschlussfläche auf, wobei die mindestens eine Öffnung einem Anbindungspunkt des mindestens einen Abstandhalters gegenüber angeordnet ist. Auf diese Weise kann ein Laserstrahl zum Laserschweißen durch die Öffnung hindurch auf den Anbindungspunkt wirken, um den Abstandhalter stoffschlüssig mit der Leiterschicht zu verbinden. Die Öffnung kann z.B. ein kleines Loch in der Oberseite des zuvor erläuterten C-Blechs sein. Der Anbindungspunkt kann ein Schweißpunkt auf der Unterseite des zuvor erläuterten C-Blechs sein. Der Abstandhalter kann mindestens eine weitere Öffnung aufweisen, z.B. in einem vertikalen Abschnitt des C-Blechs. Die weitere Öffnung kann zum Fixieren des Abstandhalters in einer Position auf der mindestens einen Leiterschicht dienen. Hierdurch kann der Abstandhalter z.B. durch einen Greifroboter in einer Position auf der Leiterschicht positioniert und fixiert werden, um das Laserschweißen präziser ausführen zu können.

Die Erfindung wird anhand von Ausführungsbeispielen näher erläutert. Die Figuren zeigen:
- Fig. 1: eine schematische Darstellung einer Ausführungsform eines Stromwandlers mit einer Vorrichtung,
- Fig. 2: eine schematische Darstellung einer weiteren Ausführungsform eines Stromwandlers mit einer Vorrichtung,
- Fig. 3: eine schematische Darstellung einer weiteren Ausführungsform eines Stromwandlers mit einer Vorrichtung,
- Fig. 4: eine schematische Darstellung einer weiteren Ausführungsform eines Stromwandlers mit einer Vorrichtung,
- Fig. 5: eine schematische Darstellung einer weiteren Ausführungsform eines Stromwandlers mit einer Vorrichtung
- Fig. 6: eine schematische Darstellung einer weiteren Ausführungsform eines Stromwandlers mit einer Vorrichtung,
- Fig. 7: eine schematische Darstellung einer weiteren Ausführungsform eines Stromwandlers mit einer Vorrichtung.

Nachfolgend bezeichnen gleiche Bezugszeichen Elemente mit gleichen technischen Merkmalen.

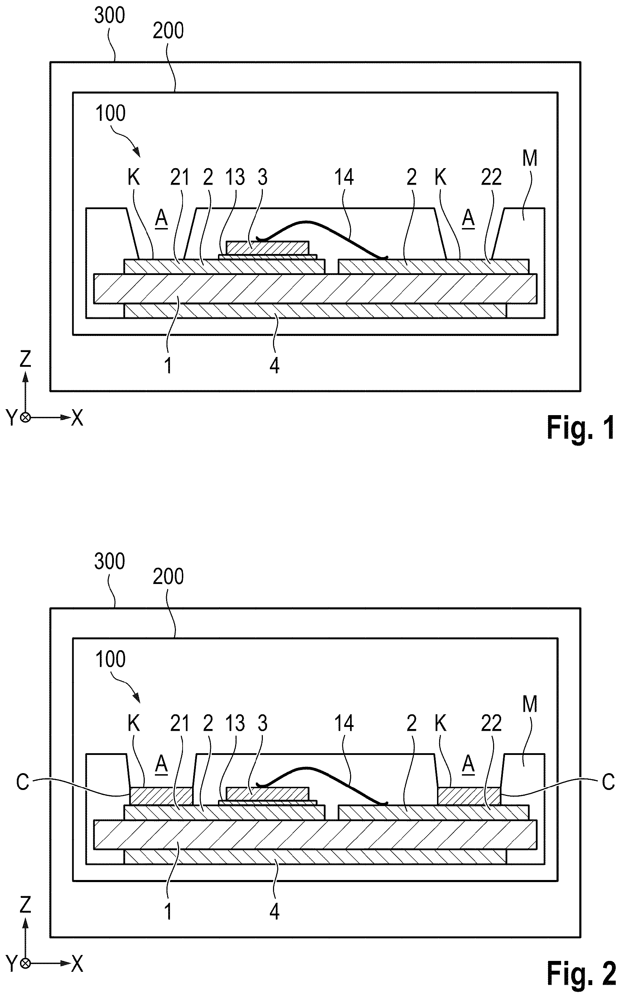

Fig. 1 zeigt eine schematische Darstellung einer Ausführungsform eines als Pulswechselrichter ausgebildeten Stromwandlers 200 mit einer Vorrichtung 100 für den Stromwandler 200.

Der Stromwandler 200 ist in einem als PKW ausgebildeten Fahrzeug 300 verbaut, welches teilweise oder vollständig elektrisch angetrieben wird. Der Stromwandler 200 wandelt z.B. Gleichstrom aus einer Hochvoltbatterie (nicht dargestellt) in Wechselstrom zum Antrieb eines Elektromotors (nicht dargestellt) um.

Zur einfacheren Erläuterung der Vorrichtung 100 ist in Fig. 1 ein fahrzeugfestes, kartesisches Koordinatensystem dargestellt. Das Koordinatensystem ist ebenfalls in den Fig. 2 bis Fig. 6 dargestellt. Eine Hochachse Z des Koordinatensystems ist z.B. entgegen einer Wirkrichtung der Schwerkraft ausgerichtet. Orthogonal zu der Hochachse Z sind jeweils eine Längsachse X und eine Querachse Y ausgerichtet. Die Längsachse X kann z.B. parallel zu einer Fahrtrichtung des Fahrzeugs 300 ausgerichtet sein. Die Querachse Y kann dementsprechend orthogonal zu der Fahrtrichtung des Fahrzeugs 300 ausgerichtet sein.

Die Vorrichtung 100 kann als Leistungsmodul bezeichnet werden. Die Vorrichtung 100 umfasst mehrere Komponenten, nämlich eine Trennschicht 1, eine Leiterschicht 2, einen Leistungshalbleiter 3 und eine Metallschicht 4. Die genannten Komponenten sind nahezu vollständig in einer z.B. aus Polyurethan hergestellten Vergussmasse M vergossen.

Die Trennschicht 1 ist z.B. aus einer Keramik hergestellt und dient als nichtleitender Schaltungsträger, der die Leiterschicht 2 von der z.B. aus Kupfer hergestellten Metallschicht 4 elektrisch isoliert. Die Trenn-, Leiter- und Metallschichten 1, 2, 4 können eine sogenannte Direct-Bonded-Copper-Struktur bilden.

Eine Unterseite der Metallschicht 4 kann zur Anbindung eines Kühlkörpers (nicht dargestellt) an die Vorrichtung 100 dienen und daher selbstverständlich frei von Vergussmasse M sein.

Die Leiterschicht 2 ist z.B. auf einer Oberseite der Trennschicht 1 angeordnet und eben ausgebildet. Die Leiterschicht 2 ist z.B. aus Kupfer hergestellt und weist mehrere Leiterbahnen 21, 22 auf, welche zum Führen unterschiedlicher elektrischer Potentiale eines Gleichstroms ausgebildet sind.

Auf der Oberseite der ersten Leiterbahn 21 der Leiterschicht 2 ist zudem ein als MOSFET ausgebildeter Leistungshalbleiter 3 angeordnet. Eine Unterseite des Leistungshalbleiters 3 ist z.B. durch Sintern mit der ersten Leiterbahn 21 elektrisch verbunden. In Fig. 1 ist daher eine Sinterschicht 13 dargestellt. Eine Oberseite des Leistungshalbleiters 3 ist z.B. über einen Bonddraht 14 mit der weiteren Leiterbahn 22 verbunden. Mit Hilfe des Leistungshalbleiters 3 kann z.B. der über die Leiterbahnen 21, 22 zugeführte Gleichstrom in Wechselstrom gewandelt werden. Hierzu kann die Vorrichtung 100 selbstverständlich weitere Leiterbahnen, Leistungshalbleiter und Wechselstromanschlüsse umfassen, welche zur besseren Übersicht in Fig. 1 nicht dargestellt sind.

Damit die Leiterbahnen 21, 22 der Leiterschicht 2 von außen kontaktierbar sind, weist jede Leiterbahn 21, 22 eine planare Anschlussfläche K auf. Die Anschlussflächen K sind somit Teilflächen der jeweiligen Leiterbahn 21, 22. Die Anschlussflächen K können kreisförmig oder eckig geformt sein. Die Anschlussflächen K können jeweils z.B. eine Größe von zwei Quadratzentimetern aufweisen. Die Anschlussflächen K können ein Gleichstromterminal der Vorrichtung 100 ausbilden.

Die Vergussmasse M weist für jede der Anschlussflächen K eine konische Aussparung A auf, wobei die jeweilige Anschlussfläche K einen Boden der Aussparung A bildet. Hierdurch können die Komponenten der Vorrichtung 100 - abgesehen von den Anschlussflächen K - in der Vergussmasse M vergossen sein und somit bestmöglich vor Umwelteinflüssen geschützt werden und die Anschlussflächen K gleichzeitig Teilflächen der ebenen Leiterschicht 2 sein.

Der Stromwandler 200 kann z.B. einen Zwischenkreiskondensator (nicht dargestellt) umfassen. Über die erste Anschlussfläche K kann z.B. eine erste Stromschiene (nicht dargestellt) des Zwischenkreiskondensators direkt mit der ersten Leiterbahn 21 elektrisch verbunden sein. Über die weitere Anschlussfläche K kann z.B. eine weitere Stromschiene (nicht dargestellt) des Zwischenkreiskondensators direkt mit der weiteren Leiterbahn 22 elektrisch verbunden sein.

Die in Fig. 1 gezeigten Anschlussflächen K haben zum Vorteil, dass eine Flexibilität bei der elektrischen Anbindung von elektronischen Komponenten des Stromwandlers 200 - wie z.B. im vorigen Absatz für den Zwischenkreiskondensator erläutert - an die Vorrichtung 100 erhöht ist. Über die Anschlussflächen K kann eine elektrische Anbindung z.B. durch Schweißen, Verlöten oder mittels einer elektrisch leitenden Feder erfolgen. Dadurch, dass jede Anschlussfläche K eine Teilfläche der Leiterschicht 2 ist, sind die Leitungswege zu dem Leistungshalbleiter 3 besonders kurz, sodass parasitäre Effekte minimiert werden.

Fig. 2 zeigt eine schematische Darstellung einer weiteren Ausführungsform eines Stromwandlers 200 mit einer Vorrichtung 100 für den Stromwandler 200.

Im Gegensatz zu der in Fig. 1 dargestellten Ausführungsform sind die Anschlussflächen K nicht eine Teilfläche der Leiterschicht 2, sondern jeweils mittels eines als Kupferquader ausgebildeten Abstandhalters C in einer Ebene parallel über der Leiterschicht 2 angeordnet. Die Abstandhalter C sind - abgesehen von der jeweiligen Anschlussfläche K - in der Vergussmasse M vergossen.

Die Anschlussfläche K sind durch den jeweiligen Abstandhalter C in einer vertikalen Richtung entlang der Hochachse Z von der Leiterschicht 2 beabstandet. Der Abstand zwischen der Leiterschicht 2 und der Anschlussfläche K kann z.B. 0,5 mm bis 1 mm betragen. Hierdurch müssen die Aussparungen A nicht so tief in die Vergussmasse M eingreifen, was wiederum eine Anbindung von elektronischen Komponenten an die Anschlussflächen K erleichtert. Der jeweilige Abstandhalter C kann z.B. durch Schweißen oder Verlöten mit der jeweiligen Leiterbahn 21, 22 der Leiterschicht 2 verbunden sein.

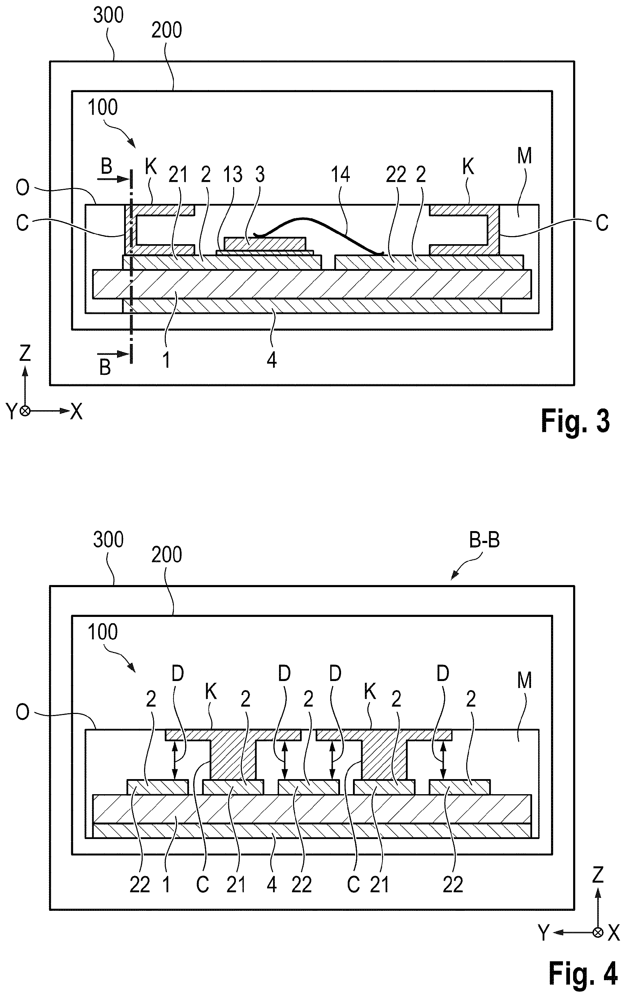

Fig. 3 zeigt eine schematische Darstellung einer weiteren Ausführungsform eines Stromwandlers 200 mit einer Vorrichtung 100 für den Stromwandler 200.

Im Gegensatz zu der in Fig. 2 dargestellten Ausführungsform weist der jeweilige Abstandhalter C in einer durch die Längsachse X und Hochachse Z aufgespannten Ebene ein C-Profil auf. Der jeweilige Abstandhalter C ist z.B. als C-Blech ausgebildet. Eine Oberseite des C-Profils bildet die jeweilige Anschlussfläche K. Das C-Profil hat zum Vorteil, dass z.B. gegenüber quaderförmigen Abstandhaltern C Gewicht und Material eingespart werden kann (vgl. Fig. 2).

Die Abstandhalter C sind zudem so in der Vorrichtung 100 angeordnet, dass die jeweilige Anschlussfläche K flächenbündig in einer Oberseite O der Vergussmasse M angeordnet ist. Die Oberseite O der Vergussmasse M bildet gleichzeitig eine Oberseite der Vorrichtung 100. Hierdurch entfällt die Notwendigkeit für eine Aussparung A (vgl. Fig. 1 und Fig. 2) in der Vergussmasse M, was wiederum eine Anbindung von elektronischen Komponenten direkt an der Oberseite O der Vergussmasse M ermöglicht. Beispielsweis durch Fertigungstoleranzen bedingt kann der jeweilige Abstandhalter C auch ein wenig aus der Oberseite O der Vergussmasse M herausragen, z.B. um 1 mm, sodass die zugehörige Anschlussfläche K in einer Ebene parallel über der Oberseite O der Vergussmasse M angeordnet sein kann.

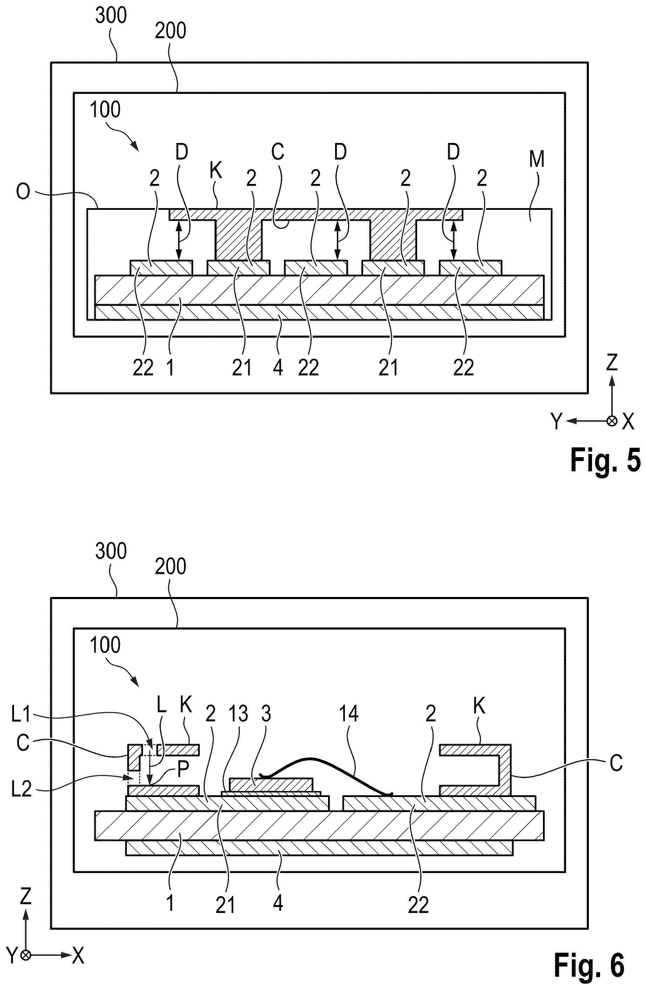

In Fig. 3 ist zudem ein Schnitt durch die Vorrichtung 100 in einer Schnittebene B-B gekennzeichnet (vgl. Fig. 4 und Fig. 5).

Fig. 4 zeigt eine schematische Darstellung einer weiteren Ausführungsform eines Stromwandlers 200 mit einer Vorrichtung 100 für den Stromwandler 200 in der Schnittebene B-B. Die Schnittebene B-B ist parallel zu einer durch die Querachse Y und die Hochachse Z aufgespannten Ebene orientiert.

In der Schnittebene B-B ist erkennbar, dass eine Leiterschicht 2 mehrere erste Leiterbahnen 21 und mehrere weitere Leiterbahnen 22 aufweist. Die ersten Leiterbahnen 21 dienen zum Führen eines ersten elektrischen Potential, z.B. eines hohen elektrischen Potentials. Die weiteren Leiterbahnen 22 dienen hingegen zum Führen eines weiteren elektrischen Potentials, z.B. eines gegenüber dem ersten elektrischen Potential niedrigen elektrischen Potentials. Die ersten und die weiteren Leiterbahnen 21, 22 sind entlang der Querachse Y alternierend angeordnet. Dies reduziert parasitäre Effekte innerhalb der Vorrichtung 100.

Die Abstandhalter C kontaktieren jeweils mit einer Unterseite die ersten Leiterbahnen 21. Jeder Abstandhalter C weist in der Schnittebene B-B ein T-Profil auf, sodass eine Anschlussfläche K auf einer Oberseite des jeweilige Abstandhalters C die zugehörige die benachbarten weiteren Leiterbahnen 22 zumindest teilweise überlappt. Die Anschlussflächen K auf der Oberseite der jeweiligen Abstandhalter C können als ein erster Gleichstromanschluss der Vorrichtung 100 dienen. Die weiteren Leiterbahnen 22 können hingegen teilweise aus der Vorrichtung 100 hervorstehen und als ein weiterer Gleichstromanschluss der Vorrichtung 100 dienen. Aufgrund des T-Profils wird einerseits die Anschlussfläche K auf einfache Weise vergrößert, andererseits werden aufgrund der Überlappung elektromagnetische Effekte zwischen den Leiterbahnen 21, 22 stärker eingegrenzt, was wiederum die parasitären Effekte verringert.

Eine Distanz D zwischen dem Abstandhalter C und der weiteren Leiterbahn 22 kann im Bereich der Überlappung z.B. zwei Zentimeter betragen. Die Distanz D ist z.B. parallel zu der Hochachse Z orientiert.

Fig. 5 zeigt eine schematische Darstellung einer weiteren Ausführungsform eines Stromwandlers 200 mit einer Vorrichtung 100 für den Stromwandler 200 in der Schnittebene B-B.

Im Gegensatz zu der in Fig. 4 gezeigten Ausführungsform ist der Abstandhalter C in Fig. 5 so ausgebildet, dass dieser mehrere erste Leiterbahnen 21 kontaktiert. Der Abstandhalter C weist in der Schnittebene B-B. ein Doppel-T-Profil auf, sodass eine Anschlussfläche K auf einer Oberseite des Abstandhalters C die zwischen den ersten Leiterbahnen 21 angeordnete weitere Leiterbahnen 22 vollständig überlappt. Aufgrund des Doppel-T-Profils wird eine Größe der Anschlussfläche K auf der Oberseite des Abstandhalters C im Vergleich zu der Ausführungsform in Fig. 4 mehr als verdoppelt. Gleichzeitig werden die elektromagnetischen Effekte zwischen der weiteren Leiterbahn 22 und dem Abstandhalter C aufgrund der geschlossenen Überlappung noch stärker eingegrenzt, was wiederum die parasitären Effekte innerhalb der Vorrichtung 100 weiter verringert.

Ferner werden aufgrund des Doppel-T-Profils auch die links- und rechtsseitig benachbarten Leiterbahnen 22 durch den Abstandhalter C zumindest teilweise überlappt.

Fig. 6 zeigt eine schematische Darstellung einer Ausführungsform eines Stromwandlers 200 mit einer Vorrichtung 100 für den Stromwandler 200.

Im Gegensatz zu Fig. 3 weist der linksseitige Abstandhalter C eine Öffnung L1 in der Anschlussfläche K auf. Die Öffnung L1 kann z.B. eine kreisrunde Bohrung oder Ausstanzung sein. Die Öffnung L1 ist einem Anbindungspunkt P des Abstandhalters C gegenüber angeordnet. Hierdurch kann z.B. ein Laserstrahl L durch die Öffnung auf den Anbindungspunkt P strahlen, um den Abstandhalter C durch Laserschweißen mit der ersten Leiterbahn 21 der Leiterschicht 2 stoffschlüssig zu verbunden.

Um den Abstandhalter C beim Anbinden leichter Positionieren und Fixieren zu können, ist in einem vertikalen Abschnitt des Abstandhalters C eine weitere Öffnung L2 vorgesehen. Diese kann ebenfalls als kreisrunde Bohrung oder Ausstanzung ausgebildet sein. In die weitere Öffnung L2 kann z.B. ein Rastwerkzeug eines Industrieroboters einrasten, um den Abstandhalter C zu ergreifen und auf der Leiterschicht 2 zu positionieren und zu fixieren.

Da das Laserschweißen selbstverständlich vor einem Vergießen der Vergussmasse M erfolgt, ist in Fig. 6 die Vergussmasse M nicht dargestellt.

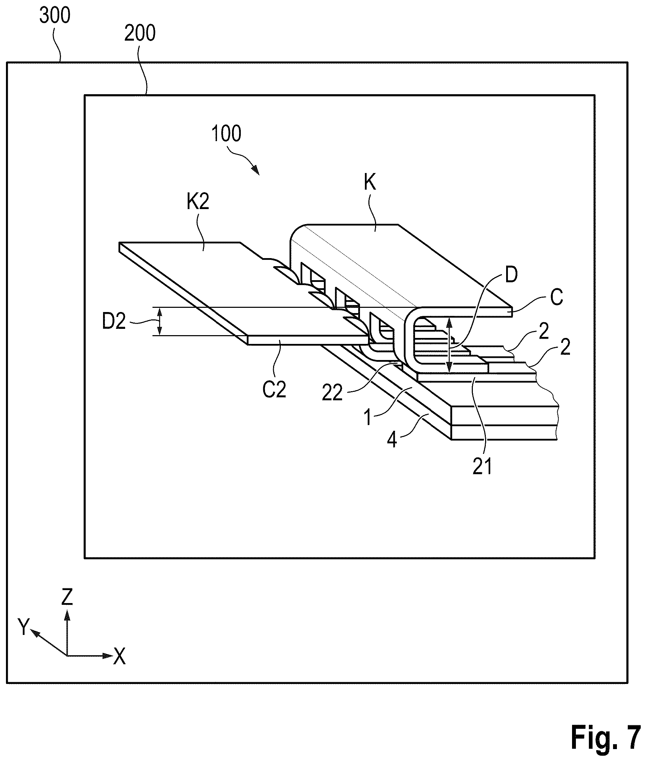

Fig. 7 zeigt eine schematische Darstellung einer weiteren Ausführungsform eines Stromwandlers 200 mit einer Vorrichtung 100 für den Stromwandler 200 in einer perspektivischen Ansicht.

In Ergänzung zu Fig. 5 ist in Fig. 7 zu erkennen, dass ein Abstandhalter C eine erste Leiterbahn 21 einer Leiterschicht 2 und ein weiterer Abstandhalter C2 eine weitere Leiterbahn 22 der Leiterschicht 2 kontaktiert. Die Abstandhalter C, C2 sind so ausgebildet, dass sie die Leiterbahnen 21, 22 alternierend in einer gemeinsamen Ebene (z.B. die X-Y-Ebene) kontaktieren.

Hierbei weist der Abstandhalter C z.B. in der Y-Z-Ebene ein mehrfaches T-Profil auf, sodass die Leiterbahnen 21, 22 vollständig von einer Anschlussfläche K des Abstandhalters C überlappt werden - mi den zuvor zu Fig. 5 erläuterten Vorteilen.

Der Abstandhalter C ist in Fig. 7 als C-Blech ausgebildet. Es sei allerdings erwähnt, dass der Abstandhalter C auch mehrere Quader (vgl. Fig. 2) aufweisen kann - sogenannte Powerspacer. Eine Oberseite der Quader könnte in diesem Fall die Anschlussfläche K bilden.

Über die Anschlussfläche K kann z.B. eine elektrische Verbindung zu einem Minuspol einer Hochvoltbatterie (nicht dargestellt) bzw. zu einem Zwischenkreiskondensator (nicht dargestellt) hergestellt werden.

Der weitere Abstandhalter C2 weist in der Y-Z Ebene ebenfalls ein mehrfaches T-Profil auf, ist im Gegensatz zu dem Abstandhalter C allerdings als sogenanntes Z-Blech ausgebildet. Der Abstandhalter C2 ist also in eine andere Richtung gebogen als der Abstandhalter C.

Der weitere Abstandhalter C2 weist eine weitere Anschlussfläche K2 auf, wobei sich die Anschlussflächen K, K2 aufgrund der Biegung des weiteren Abstandhalters C nicht überlappen. Dies vereinfacht die Anbindung von Stromschienen. Über die weitere Anschlussfläche K2 kann z.B. eine elektrische Verbindung zu einem Pluspol einer Hochvoltbatterie (nicht dargestellt) bzw. zu einem Zwischenkreiskondensator (nicht dargestellt) hergestellt werden.

Eine Distanz D2 zwischen den Anschlussflächen K, K2 (entlang der Hochachse Z) kann mit Hilfe der Abstandhalter C, C2 auf ein konstruktives Minimum reduziert werden, z.B. auf ein Minimum von 3 mm. Beispielsweise kann ein Abstand zwischen den stromführenden Stromschienen (nicht dargestellt), welche die Vorrichtung 100 mit dem Zwischenkreiskondensator (nicht dargestellt) elektrisch verbinden auf die Distanz D2 minimiert werden. Hierdurch können parasitäre Effekte besonders effektiv reduziert werden.

### Bezugszeichenliste

- 1: Trennschicht
- 2: Leiterschicht
- 21: erste Leiterbahn
- 22: weitere Leiterbahn
- 3: Leistungshalbleiter
- 4: Metallschicht
- 13: Sinterschicht
- 14: Bonddraht
- 100: Vorrichtung
- 200: Stromwandler
- 300: Fahrzeug
- A: Aussparung
- B-B: Schnittebene
- C: Abstandhalter
- C2: weiterer Abstandhalter
- D: Distanz
- D2: Distanz zwischen Anschlussflächen
- K: Anschlussfläche
- K2: weitere Anschlussfläche
- L: Laserstrahl
- L1: Öffnung
- L2: weitere Öffnung
- M: Vergussmasse
- O: Oberseite der Vergussmasse
- P: Anbindungspunkt
- X: Längsachse
- Y: Querachse
- Z: Hochachse

## Patentansprüche

1. Vorrichtung (100) für einen Stromwandler (200), umfassend:
- mindestens eine Trennschicht (1),
- mindestens eine Leiterschicht (2),
- mindestens einen Leistungshalbleiter (3),
wobei die mindestens eine Trennschicht (1), die mindestens eine Leiterschicht (2) und der mindestens eine Leistungshalbleiter (3) zumindest teilweise in einer Vergussmasse (M) vergossen sind, wobei die Vorrichtung (100) mindestens eine Anschlussfläche (K) zur elektrischen Kontaktierung aufweist, wobei die Vergussmasse (M) die mindestens eine Anschlussfläche (K) nicht bedeckt, wobei die mindestens eine Anschlussfläche (K) planar ausgebildet ist, wobei die mindestens eine Anschlussfläche (K) als eine Teilfläche der mindestens einen Leiterschicht (2) ausgebildet ist oder in einer Ebene parallel über der mindestens einen Leiterschicht (2) angeordnet ist.

2. Vorrichtung (100) nach Anspruch 1, **dadurch gekennzeichnet, dass** die Vergussmasse (M) mindestens eine Aussparung (A) aufweist, wobei die mindestens eine Anschlussfläche (K) einen Boden der Aussparung (A) ausbildet.

3. Vorrichtung (100) nach einem der vorangegangenen Ansprüche, **dadurch gekennzeichnet, dass** die mindestens eine Anschlussfläche (K) mittels mindestens eines Abstandhalters (C) in der Ebene parallel über der mindestens einen Leiterschicht (2) angeordnet ist.

4. Vorrichtung (100) nach Anspruch 3, **dadurch gekennzeichnet, dass** die mindestens eine Anschlussfläche (K) flächenbündig in einer Oberseite (O) der Vergussmasse (M) angeordnet ist.

5. Vorrichtung (100) nach Anspruch 3 oder 4, **dadurch gekennzeichnet, dass** der mindestens eine Abstandhalter (C) ein C-Profil aufweist.

6. Vorrichtung (100) nach einem der Ansprüche 3 bis 5, **dadurch gekennzeichnet, dass** die mindestens eine Leiterschicht (2) mindestens eine erste Leiterbahn (21) mit einem ersten elektrischen Potential und mindestens eine weitere Leiterbahn (22) mit einem weiteren elektrischen Potential aufweist, wobei der mindestens eine Abstandhalter (C) die mindestens eine erste Leiterbahn (21) kontaktiert, wobei der mindestens eine Abstandhalter (C) derart ausgebildet ist, dass der mindestens eine Abstandhalter (C) die mindestens eine weitere Leiterbahn (22) in einer Raumrichtung zumindest teilweise überlappt.

7. Vorrichtung (100) nach einem der Ansprüche 3 bis 6, **dadurch gekennzeichnet, dass** der mindestens eine Abstandhalter (C) mehrere erste Leiterbahnen (21) eines ersten elektrischen Potentials kontaktiert, wobei zwischen den ersten Leiterbahnen (21) mindestens eine weitere Leiterbahn (22) eines weiteren elektrischen Potentials angeordnet ist, wobei der mindestens eine Abstandhalter (C) derart ausgebildet ist, dass der mindestens eine Abstandhalter (C) die mindestens eine weitere Leiterbahn (22) in einer Raumrichtung vollständig überlappt.

8. Vorrichtung (100) nach einem der Ansprüche 3 bis 7, **dadurch gekennzeichnet, dass** der mindestens eine Abstandhalter (C) mindestens eine Öffnung (L1) in der mindestens einen Anschlussfläche (K) aufweist, wobei die mindestens eine Öffnung (L1) einem Anbindungspunkt (P) des mindestens einen Abstandhalters (C) gegenüber angeordnet ist.

9. Stromwandler (200), umfassend mindestens eine Vorrichtung (100) nach einem der Ansprüche 1 bis 8.

10. Fahrzeug (300), umfassend mindestens einen Stromwandler (200) nach Anspruch 9.
